# EUROPEAN PATENT APPLICATION

(11) **EP 4 813 931 A1**
(43) Date of publication of application: **30.09.2026**
(21) Application number: 25814966.5
(22) Date of filing: 09.04.2025
(51) Int. Cl.: C02F 1/44, B01D 61/14, B01D 63/08, B01D 65/02, B01D 65/04, B01D 69/10, B01D 69/12, G03F 7/30

(54) **METHOD AND DEVICE FOR PRODUCING RECYCLED DEVELOPER FROM DEVELOPMENT WASTE LIQUID**

(30) Priority: 27.05.2024 JP 2024085609
(71) Applicant: TOYOBO MC Corporation, Osaka-shi, Osaka 530-0001 (JP)
(72) Inventor: KAWASHIMA, Wataru, Okayama-shi, Okayama 704-8194 (JP); MANABE, Ryosuke, Otsu-shi, Shiga 520-0292 (JP)
(74) Representative: Müller-Boré & Partner Patentanwälte PartG mbB
(86) International application number: PCT/JP2025/014223
(87) International publication number: WO 2025/248988

(57) **Abstract**

The present invention provides a method for producing a regenerated developer that can efficiently filter-out and remove the photosensitive resin composition from the development waste liquid generated by developing a water-developable flexographic printing plate precursor, regardless of whether the photosensitive resin composition forms flocculate or not, while maintaining high filtration performance and enabling the developing waste liquid to be concentrated to a high concentration for disposal. The method comprises: guiding the development waste liquid into a processing tank, and separating and removing the photosensitive resin composition which has been contained in the development waste liquid using a polymer porous flat membrane sheet provided in the processing tank to obtain the regenerated developer; and charging sponge pieces into the processing tank and aerating the polymer porous flat membrane sheet such that the sponge pieces hit on the polymer porous flat membrane sheet, thereby removing deposits on the polymer porous flat membrane sheet therefrom for cleaning the flat membrane sheet.

## Description

### Technical Field

The present invention relates to a method and an apparatus for producing a regenerated developer from a development waste liquid. More particularly, the present invention relates to a method and an apparatus capable of efficiently filtering-out and removing a photosensitive resin composition from a development waste liquid generated by developing a water-developable flexographic printing plate precursor having a photosensitive resin layer, regardless of whether the photosensitive resin composition forms flocculate or not.

### Background Art

Flexographic printing plate precursors generally have a structure in which a photosensitive resin layer formed from a photosensitive resin composition is provided on a support. From such flexographic printing plate precursors, flexographic printing plates are produced, for example, by selectively exposing the photosensitive resin layer with ultraviolet light and then developing the exposed photosensitive resin layer with a water-based developer. The photosensitive resin composition in the unexposed portions of the photosensitive resin layer is physically removed from the printing plate by brushing during development and dispersed or dissolved in the developer. Repeated development of the photosensitive resin layer using the same developer leads to an increase in concentration of the photosensitive resin composition dispersed in the developer, thereby leading to a decrease in development speed and/or flocculation of the dispersed photosensitive resin composition to form flocculate. The flocculate re-adheres to surface of the printing plate, thereby degrading quality of the plate surface. Therefore, it is necessary to dispose of the developer with an increased concentration of the photosensitive resin composition and replace it with a new developer to resume plate making. However, repeatedly disposing of used developer and replacing it with a new developer is undesirable in terms of environmental impact and manufacturing costs. Therefore, it has been attempted to remove the photosensitive resin composition from used developer so as to produce a regenerated developer for reuse.

For example, Patent Document 1 proposes an apparatus in which a developer regenerating means collects the used developer, removes a suspended matter therefrom, and supplies the treated developer to a developer supplying means, thereby enabling the developer to be regenerated and recycled for reuse. This apparatus can collect the photosensitive resin composition that has flocculated in the developer by removing the suspended matter with a filter. However, in this apparatus, the photosensitive resin composition which has not flocculated but has dispersed in the developer passes through the filter and thus cannot be collected. If mesh size of the filter used is made finer as a countermeasure, the filter needs to be replaced frequently, resulting in poor efficiency. Furthermore, if a flocculant is used to floccurate the photosensitive resin composition for collection, there are problems in terms of cost of the flocculant and efficiency.

In order to overcome the problems of Patent Document 1, Patent Document 2 proposes a developing apparatus comprising a dispersion filter for flocculating a photosensitive resin composition which has been dispersed in a developer, and a flocculation filter for removing the flocculated photosensitive resin composition from the developer that has passed through the dispersion filter, wherein the developer from which the flocculated photosensitive resin composition has been removed is allowed to settled for separation into a high-concentration layer and a low-concentration layer. This apparatus can flocculate and collect the photosensitive resin composition which has not flocculated but has dispersed in the developer. However, this apparatus suffers from a problem that the developer must be allowed to settle for separation into the high-concentration layer and the low-concentration layer, which requires a prolonged time for separation and prevents the used developer from being efficiently concentrated and the photosensitive resin composition from efficiently separated.

### Prior Art Documents

### Patent Documents

Patent Document 1: Japanese Patent Application Laid-Open (JP-A) No. 258458/97
Patent Document 2: Japanese Patent Application Laid-Open (JP-A) No. 2011-232407

### Disclosure of the Invention

### Problem that the Invention is to Solve

The present invention was devised to solve the problems of the prior art described above, and its objective is to provide a method and an apparatus for producing a regenerated developer that can efficiently filter-out and remove the photosensitive resin composition from the development waste liquid generated by developing a water-developable flexographic printing plate precursor, regardless of whether the photosensitive resin composition forms flocculate or not, while maintaining high filtration performance and enabling the developing waste liquid to be concentrated to a high concentration for disposal. Means for Solving the Problem

In order to achieve this objective, the present inventors have investigated an efficient method for filtering-out and separating the photosensitive resin composition from development waste liquid, and a method for maintaining filtration performance. As a result, the present inventors adopted, as a means for filtering-out and separating the photosensitive resin composition, a polymer porous flat membrane sheet, which had not been conventionally used for the regeneration of used developer. Microfiltration membranes are difficult to use because they tend to clog due to presence of a synthetic rubber-based polymer in the photosensitive resin composition. However, flat membrane sheets exhibit high membrane cleaning property by aeration. Specifically, in the flat membrane sheets, the photosensitive resin composition adhering to membrane surface and between the membranes can be efficiently removed by aeration. However, when the development waste liquid is concentrated to a high concentration, the photosensitive resin composition, in some cases, flocculates and adheres to surface of the flat membrane sheet, thereby causing clogging. In order to deal with such a problem, the present inventors thought up a cleaning method wherein soft sponge pieces hit on the filtration surface of the flat membrane sheet during aeration. By adopting such a cleaning method, it is possible to filter-out not only flocculate of the photosensitive resin composition from the development waste liquid, but also photosensitive resin composition that has not flocculated but has dispersed. Furthermore, deposits tend to accumulate on the surface of the flat membrane sheet in accordance with the filtration-out and separation by the flat membrane sheet. The present inventors found that such deposits can be easily removed with the sponge pieces for cleaning the flat membrane sheet, and, as a result, the development waste liquid can be concentrated to a high concentration for disposal.

That is, the present invention was completed based on the above findings and has the following configurations (1) to (6).
(1) A method for producing a regenerated developer from a development waste liquid generated by developing a water-developable flexographic printing plate precursor having a photosensitive resin layer made of a photosensitive resin composition containing a water-dispersible resin, comprising:
   guiding the development waste liquid into a processing tank, and separating and removing the photosensitive resin composition which has been contained in the development waste liquid using a polymer porous flat membrane sheet provided in the processing tank to obtain the regenerated developer; and
   charging sponge pieces into the processing tank and aerating the polymer porous flat membrane sheet such that the sponge pieces hit on the polymer porous flat membrane sheet, thereby removing deposits on the polymer porous flat membrane sheet therefrom for cleaning the flat membrane sheet.
(2) The method according to (1), wherein the polymer porous flat membrane sheet comprises a polymer porous membrane that forms a mesh-like network structure and a sheet-like substrate that supports the polymer porous membrane.
(3) The method according to (1) or (2), wherein the sponge pieces are made of a material that has a specific gravity greater than a specific gravity of the liquid in the processing tank when the sponge pieces retain water and wherein the material has a maximum edge dimension of 0.1 to 10 mm.
(4) An apparatus for producing a regenerated developer from a development waste liquid generated by developing a water-developable flexographic printing plate precursor having a photosensitive resin layer made of a photosensitive resin composition containing a water-dispersible resin,
   wherein the apparatus has a processing tank for receiving the development waste liquid and separating and removing the photosensitive resin composition which has been contained in the development waste liquid,
   wherein the processing tank is equipped with a polymer porous flat membrane sheet for separating and removing the photosensitive resin composition from the development waste liquid, and
   wherein the processing tank comprises sponge pieces charged into the processing tank and a cleaning means configured to remove deposits on the polymer porous flat membrane sheet therefrom by aerating the polymer porous flat membrane sheet such that the sponge pieces hit on the polymer porous flat membrane sheet.
(5) The apparatus according to (4), wherein the polymer porous flat membrane sheet comprises a polymer porous membrane that forms a mesh-like network structure and a sheet-like substrate that supports the polymer porous membrane.
(6) The apparatus according to (4) or (5), wherein the sponge pieces are made of a material that has a specific gravity greater than a specific gravity of the liquid in the processing tank when the sponge pieces retain water, and wherein the material has a maximum edge dimension of 0.1 to 10 mm.

### Effects of the Invention

The method and the apparatus according to the present invention adopt, as a means of filtering-out and separating the photosensitive resin composition from the development waste liquid, a high-performance polymer porous flat membrane sheet with fine pores. Therefore, not only flocculates of the photosensitive resin composition but also the photosensitive resin composition that has not flocculated but has dispersed can be efficiently removed from the development waste liquid to easily obtain a regenerated developer. Furthermore, the method and the apparatus according to the present invention are configured such that sponge pieces are charged into the processing tank in which the polymer porous flat membrane sheet is immersed, and the flat membrane sheet is aerated so that the sponge pieces hit on the surface of the flat membrane sheet, thereby removing and cleaning deposits adhered to the surface of the flat membrane sheet. Therefore, clogging of the flat membrane sheet is unlikely to occur, high filtration performance can be continuously maintained, and the development waste liquid can be concentrated to a high concentration for disposal.

### Brief Description of the Drawing

[Figure 1] Figure 1 is a schematic diagram of an example of a developing process system that incorporates the apparatus according to the present invention for producing a regenerated developer from development waste liquid.
[Figure 2] Figure 2 is a schematic diagram of an example of the apparatus according to the present invention for producing a regenerated developer from development waste liquid.
[Figure 3] Figure 3 is a schematic diagram of an example of a method for removing deposits from surface of a polymer porous flat membrane sheet using the apparatus according to the present invention.

### Mode for Carrying Out the Invention

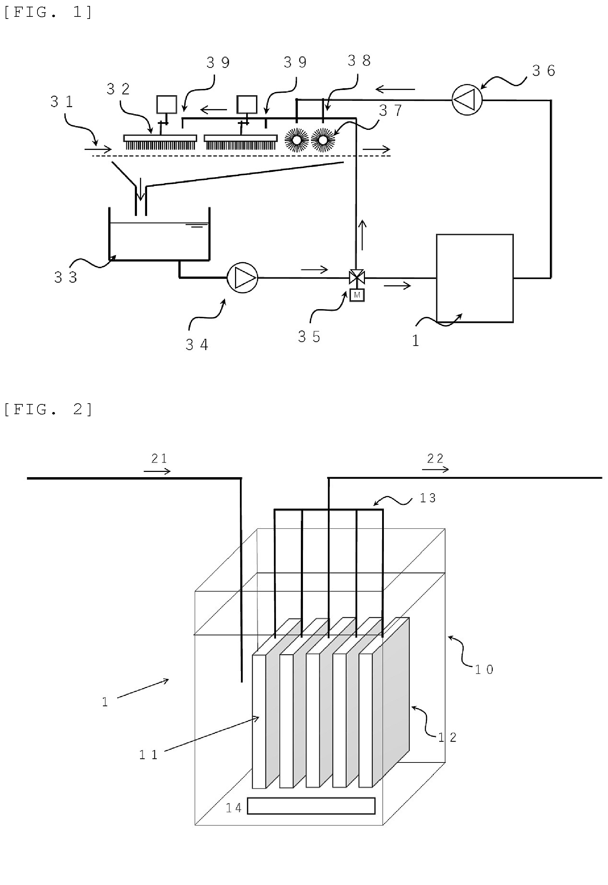

The apparatus and the method of the present invention are for producing a regenerated developer from a development waste liquid generated by developing a water-developable flexographic printing plate having a photosensitive resin layer made of a photosensitive resin composition. The apparatus of the present invention is used by being incorporated into a general developing process system, for example, as shown in Figure 1.

Figure 1 schematically shows an example of a developing process system incorporating the apparatus of the present invention. As shown in Figure 1, a water-developable flexographic printing plate precursor (not shown) having a photosensitive resin layer enters the developing process system and moves along a transport direction 31. First, the water-developable flexographic printing plate precursor is developed by making a developing brush 32 perform a relative scrubbing motion in the presence of developer discharged from a developer outlet 39. During development, the portions of the photosensitive resin layer of the flexographic printing plate precursor that were not exposed in the previous process are removed. The developer used in development is transferred to a developer tank 33 and stored therein.

Next, the flexographic printing plate is scrubbed on its surface by a roll-shaped rinse brush 37 while the developer or water discharged from a regenerated developer outlet 38 is applied, whereby debris remaining on the plate are removed. The developer used here is also transferred to the developer tank 33 and stored therein. The liquid stored in the developer tank 33 is transferred to the developer outlet 39 via a transfer switching valve 35 by a developer pump 34 for reuse as a developer, or is regenerated by removing the photosensitive resin composition in the apparatus 1 of the present invention for producing regenerated developer and then transferred to the regenerated developer outlet 38. Figure 1 shows a general example of a developing process system. The apparatus 1 of the present invention for producing regenerated developer can be similarly incorporated into developing process systems with other configurations.

The flexographic printing plate precursor to be developed has, on a support, a photosensitive resin layer made of a photosensitive resin composition containing a water-dispersible resin, and can be washed with a water-based developer as a washout liquid. The photosensitive resin composition forming the photosensitive resin layer is preferably water-developable and contains a synthetic rubber-based polymer, a photopolymerizable unsaturated monomer compound, and a photopolymerization initiator as its main components.

As to the support to be used for the flexographic printing plate precursor, a material that is flexible and exhibits excellent dimensional stability is preferred. Examples thereof include metal supports such as steel, aluminum, copper, and nickel, and thermoplastic resin supports such as polyethylene terephthalate film, polyethylene naphthalate film, polybutylene terephthalate film, and polycarbonate film. Among these, polyethylene terephthalate film is particularly preferred because it exhibits excellent dimensional stability and sufficiently high viscoelasticity.

The synthetic rubber-based polymer is used for imparting appropriate rubber elasticity to the photosensitive resin layer, and conventionally known rubber components can be used. The synthetic rubber-based polymer is preferably solid at room temperature for imparting rubber elasticity. Examples of the synthetic rubber-based polymer include polybutadiene, polychloroprene, polyacrylonitrile-butadiene, polyacrylic polymer, epichlorohydrin rubber, polyurethane, polyisoprene, polystyrene-isoprene copolymer, polystyrene-butadiene copolymer, methyl methacrylate-butadiene copolymer, ethylene-propylene copolymer, butyl rubber, and chlorinated polyethylene. Polymers obtained by copolymerizing these polymers with other components such as acrylic acid or methacrylic acid can also be used. Among the synthetic rubber-based polymers, a water-dispersible synthetic rubber-based polymer having a butadiene skeleton and/or a styrene skeleton is preferred in terms of developability and physical properties. As to the water-dispersible synthetic rubber-based polymer, water-dispersible latex is preferred. As to the water-dispersible latex, latex having a cross-linked structure in the molecule can be used. As to the latex having a cross-linked structure in the molecule, a hydrophobic polymer obtained from water-dispersible latex with a weight-average gelation degree of 20-80 % is preferred. Water-dispersible latex is a stable suspension in which fine particles of rubber polymer are dispersed in water. The polymer is obtained by removing water from this water-dispersible latex.

The photosensitive resin composition may contain a water-insoluble synthetic rubber-based polymer to the extent that the water-insoluble synthetic rubber-based polymer does not adversely affect the performance of the photosensitive resin composition. Examples of such water-insoluble polymers include polybutadiene, polychloroprene, polyacrylonitrile-butadiene, polyurethane, polyisoprene, polystyrene-isoprene copolymer, and polystyrene-butadiene copolymer.

The photosensitive resin composition may contain a water-soluble or water-dispersible polymer other than the water-dispersible synthetic rubber-based polymer. Examples of the water-soluble or water-dispersible polymer include water-soluble polyamides and water-dispersible polyamides obtained by introducing hydrophilic groups into polyamides, partially saponified polyvinyl acetate and its derivatives, and anionic acrylic-based polymers.

The photopolymerizable unsaturated monomer compound are used for crosslinking and curing by ultraviolet light. The photopolymerizable unsaturated monomer compound may have only one ethylenically unsaturated bond, or may have two or more ethylenically unsaturated bonds. The photopolymerizable unsaturated monomer compound may also contain an oligomer or a polymer into which photopolymerizable groups have been introduced. In terms of compatibility with the synthetic rubber-based copolymer, it is preferable that the photopolymerizable unsaturated monomer compound contains one that has a common skeleton with the synthetic rubber-based copolymer.

The photopolymerization initiator is used for polymerizing polymerizable unsaturated groups by light irradiation. In particular, the photopolymerization initiator that has the function of generating radicals by self-decomposition or hydrogen abstraction upon light absorption are preferred. Specific examples of the photopolymerization initiator include benzoin alkyl ethers, benzophenones, anthraquinones, benzyls, acetophenones, and diacetyls. The photopolymerization initiator may be used alone or in combination of two or more types.

The developer used in the present invention is a water-based developer mainly composed of water, and is used for removing water-dispersible uncured portions of the photosensitive resin. The water-based developer may be water alone, or may be an aqueous solution to which a water-soluble developing accelerator has been added. Examples of the developing accelerator include surfactants, acids, bases, and salts. In terms of development speed, it is preferable to add a water-soluble developing accelerator. As to the developing accelerator, commercially available soap or detergent may be used.

Examples of the surfactants include cationic surfactants, anionic surfactants, and nonionic surfactants. Examples of the acids include inorganic acids such as sulfuric acid, nitric acid, and phosphoric acid, and organic acids such as formic acid, acetic acid, oxalic acid, succinic acid, citric acid, maleic acid, and p-toluenesulfonic acid. Examples of the bases include lithium hydroxide, sodium hydroxide, potassium hydroxide, and calcium hydroxide. The developing accelerator may be a combination of the surfactants, the acids, the bases, and the salts. The optimal blend of developing accelerators may be determined according to the components of the photosensitive resin composition.

The water-based developer may contain water-soluble organic solvents other than water. Examples of such organic solvents include methanol, ethanol, isopropyl alcohol, cellosolve, glycerin, ethylene glycol, and polyethylene glycol. Furthermore, a defoaming agent may be added for suppressing foam formation. Any water-soluble defoaming agent can be used, and examples of components of the defoaming agent include higher alcohols, fatty acid derivatives, silica, anodized aluminum, and silicone.

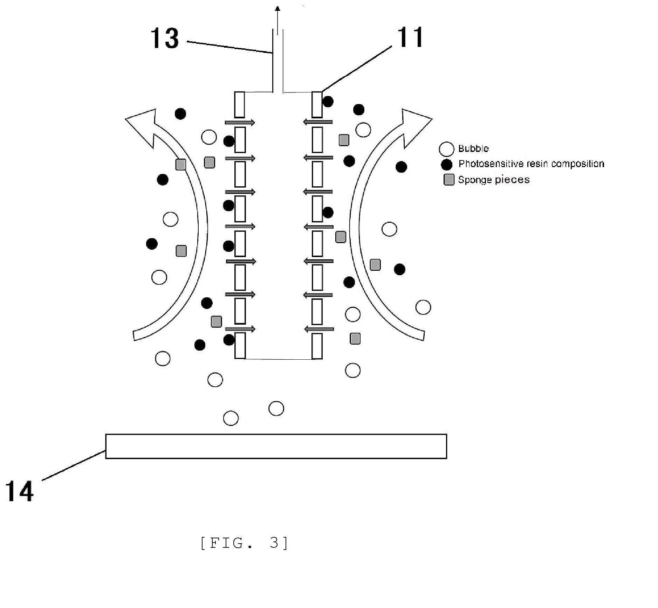

Next, the configuration of the apparatus of the present invention will be explained using Figures 2 and 3. The first feature of the apparatus of the present invention is use of a polymer porous flat membrane sheet for separating and removing the photosensitive resin composition which has been contained in the development waste liquid. Conventionally, the filtration-out and removal of the photosensitive resin composition from the development waste liquid in the processing tank was carried out mainly by using filters. While the filters are effective in filtering-out and removing flocculated photosensitive resin composition, it was difficult to remove photosensitive resin composition that has not flocculated but has dispersed in the liquid. In the present invention, by adopting a polymer porous flat membrane sheet with fine pores that has not been conventionally used in this field, it is possible to filter-out and remove any type of the photosensitive resin composition, regardless of whether the photosensitive resin composition forms flocculate or not.

The usage mode of the polymer porous flat membrane sheet in the present invention will be explained with reference to a schematic diagram of an example of the apparatus of the present invention shown in Figure 2. As shown in Figure 2, the apparatus 1 of the present invention has the processing tank 10 that receives the development waste liquid transferred from a developer tank in a transport direction 21, and membrane elements 12 comprising a number of polymer porous flat membrane sheets 11 are immersed in the development waste liquid in the processing tank 10. The photosensitive resin composition is separated and removed from the development waste liquid in the processing tank 10 by the polymer porous flat membrane sheets 11 and collected through a water collection pipe 13 connected to each of the flat membrane sheets 11. The collected, filtered-out development waste liquid is transferred as a regenerated developer in a transport direction 22 and supplied to a developing brush or a rinsing brush. Conventional known polymer porous flat membrane sheets can be used as appropriate, and their details will be described later.

The second feature of the apparatus of the present invention is that sponge pieces are charged into the processing tank 10 and that a cleaning means 14 is provided that allows for cleaning by aerating the polymer porous flat film sheets 11 such that the sponge pieces in the development waste liquid hit on the flat film sheets 11, thereby removing deposits on surface of the flat film sheets 11 therefrom. When the flat film sheets 11 are continuously used for removing the photosensitive resin composition from the development waste liquid, the photosensitive resin composition and the like that have not been filtered-out adhere to and accumulate on the surface of the flat film sheets 11 and, making the flat film sheets 11 prone to clogging. The cleaning means 14 of the present invention enables continuous use of the high-performance flat film sheets 11 without reducing filtration efficiency by making the soft sponge pieces hit on the deposits on the surface of the flat film sheets 11 in the liquid and removing them.

A method for removing the deposits from the surface of the flat film sheets 11 using the cleaning means 14 of the present invention will be explained with reference to the schematic diagram in Figure 3. As shown in Figure 3, in the processing tank 10 of the apparatus 1 of the present invention, the flat film sheet 11 is immersed together with sponge pieces in the development waste liquid containing the photosensitive resin composition. The cleaning means 14 enables to remove the deposits on the surface of the flat film sheet 11 therefrom by aerating the flat film sheet 11 such that the sponge pieces hit on the flat film sheet 11.

The cleaning means 14 has a role of generating bubbles in the development waste liquid in the processing tank 10. These bubbles make the sponge pieces in the processing tank 10 flow and hit on the flat film sheet 11. The cleaning means 14 is not particularly limited as long as it can achieve the above role. For one example, the cleaning means 14 can be a tubular member installed below the flat film sheet. On the top of the tubular member, perforations are formed. Air is introduced into the tubular member and aerated from the perforated portion to transfer the air to the surface of the flat film sheet. For another example, the cleaning means 14 can be multiple nozzles or the like to transfer air directly toward the surface of the flat film sheet.

The sponge pieces preferably have a specific gravity greater than a specific gravity of the liquid in the processing tank 10 when the sponge pieces retain water (for example, the specific gravity of 1.02 or higher when the sponge pieces retain water). If the specific gravity of the sponge pieces is lower than the specific gravity of the liquid in the processing tank 10 when the sponge pieces retain water, the sponge pieces may float on the liquid surface of the processing tank 10, potentially impairing the cleaning function. The material of the sponge pieces is not particularly limited as long as the surface is flexible, and either organic or inorganic materials can be used. Usable examples of the material include conventionally known sponge materials such as polyvinyl alcohol, polyolefins such as polyethylene, and polypropylene, EVA resin, polyurethane foam, polyester, nylon, melamine foam, and processed sea sponges. In addition, since the flat film sheet 11 of the apparatus of the present invention is used to remove the photosensitive resin composition, the sponge pieces do not need to be microbial immobilization carriers. In terms of easily removing the synthetic rubber-based polymer in the photosensitive resin composition from the surface of the flat film sheet, it is preferable that the sponge pieces have high water absorption and water retention and excellent abrasion resistance, and polyvinyl alcohol, polyolefin, EVA resin, polyurethane foam are preferred.

The size of the sponge pieces is not particularly limited as long as they can easily remove the deposits from the surface of the flat film sheet 11. It is preferable that the maximum edge dimension is 1 to 10 mm. The shape of the sponge pieces is not particularly limited as long as they have fluidity in the liquid, and they may be spherical, cubic, polyhedron, or similar shapes. It is preferable that the surface of the sponge pieces has moderate irregularities, and voids may also be provided inside the sponge pieces. In terms of cleaning performance and fluidity performance, the amount of sponge pieces used is preferably 1% by mass or more and less than 40% by mass of the amount of development waste liquid. If the amount of sponge pieces used is less than 1% by mass, the amount of the sponge pieces in contact with the flat film sheet 11 is small and the cleaning function tends to decrease. Also, if the amount of sponge pieces used is 40% by mass or more, the fluidity of the sponge pieces in the development waste liquid becomes poor and the cleaning function tends to be impaired.

After filtration, new development waste liquid is added to the concentrated development waste liquid obtained in the processing tank 10 from the transport direction 21, and the photosensitive resin composition can be repeatedly separated and removed. According to the present invention, by repeatedly separating and removing the photosensitive resin composition, the concentrated development waste liquid can be concentrated to a further higher concentration before disposal, thereby reducing the amount of concentrated waste liquid.

The polymer porous flat membrane sheet used in the present invention preferably comprises a polymer porous membrane (membrane material) that forms a mesh-like network structure and a sheet-like substrate (membrane substrate) that supports the polymer porous membrane. The membrane substrate not only supports the membrane material and maintains the shape of the membrane, but also plays a role in absorbing stress applied on the membrane. The polymer material constituting the membrane material can function as a separation membrane by appropriately intertwining with the membrane substrate and forming an appropriate porous structure.

The membrane substrate is preferably composed of a nonwoven fabric made of a polymer material that is insoluble in organic solvents and water, and is not limited as long as it has the ability to retain the membrane components and to absorb the stress applied on the membrane. The nonwoven fabric is preferably made of hydrocarbon-based, olefin-based, or condensation-based polymers. Examples thereof include polyethylene, polyolefin, polyvinyl alcohol, polyethylene terephthalate, nylon, polyimide, polytetrafluoroethylene, and polyvinyl chloride.

The thickness of the nonwoven fabric is preferably 80 to 150 µm. Since the nonwoven fabric is used as a water-permeable membrane substrate, an excessively large thickness may hinder water permeability, whereas an excessively small thickness may result in sufficient strength and may not withstand long-term use.

In order to ensure the strength of the nonwoven fabric, it is preferable to fix the fibers together with a binder. As to methods for fixing the fibers, any method may be used, such as a method of using a fiber having a core-sheath structure in which the binder component is formed in the sheath portion, or a method of impregnating the nonwoven fabric with an adhesive component after producing the nonwoven fabric. A preferred method is to produce the nonwoven fabric together with binder fibers and then thermally fuse the fibers to bond them to one another. After producing the nonwoven fabric by appropriately combining drawn and undrawn yarns, heat and pressure are applied. At this time, the undrawn yarns soften at a lower temperature than the drawn yarns, thus acting as a binder.

As to methods for producing the nonwoven fabric, any method may be used, such as a melt-blown method, a thermal-bonding method, or a papermaking method. The fiber diameter and basis weight should be selected to ensure liquid permeability. The fiber diameter is preferably 5 to 12 µm, and more preferably 7 to 10 µm. If the fiber diameter is too small, the strength may be low and the nonwoven fabric may not withstand long-term use. If the fiber diameter is too large, the overall balance may be insufficient, and the strength may not have enough strength. Therefore, the nonwoven fabric may not withstand long-term use. Furthermore, if the fiber diameter is too large relative to the membrane thickness, the nonwoven fabric may have a rough overall structure. As a result, the polymer components constituting the membrane may not be sufficiently retained in the nonwoven fabric, leading to defects and other problems, or the amount of polymer filled may be insufficient, potentially causing an excessive formation of voids in the membrane. The basis weight of the nonwoven fabric per 1 µm of membrane thickness is preferably 0.4 to 0.8 g/ m², and more preferably 0.5 to 0.7 g/m². It is preferable that the basis weight is small, but if the basis weight is too small, the strength may be reduced, and the nonwoven fabric may not withstand long-term use as a membrane. If the basis weight is too large, the voids may be reduced, potentially resulting in poor liquid permeability.

The membrane material is preferably composed of a hydrophobic polymer material such as polyvinyl chloride and/or chlorinated polyvinyl chloride, and formed into a mesh-like network structure having submicron-sized pores by a phase separation method. Examples of the phase separation method include a method of mixing a polymer material with a solvent to prepare a solution, applying it to a nonwoven fabric substrate and drying it in the air (dry method), a method of introducing the substrate coated with the polymer solution into a solidification bath and allowing it to solidify (wet method), and a method of rapidly changing the temperature (thermal-induced phase separation method). Among them, the dry method, in which the substrate coated with the polymer solution is dried in the gas phase, is preferred since the dry method allows for easy control of the membrane formation and does not require complex equipment.

The solvent for dissolving the polymer material needs to dissolve the polymer forming the membrane but not the nonwoven fabric, and solvents that are volatile at approximately 150 °C or below, or that are water-soluble can be used. Specifically, tetrahydrofuran (THF), toluene, dimethylformamide (DMF), N-methyl-2-pyrrolidone (NMP), and dimethylacetamide (DMAC) are suitable, and may be used alone or in combination. When performing membrane formation by the dry method, the solvent is evaporated in the gas phase to form the membrane. Therefore, it is preferable to use THF or a mixed solvent having THF as the main component (50% by weight or more).

As to the non-solvent, water or alcohol is preferred. Among alcohols, ethanol (EtOH), propanol (1- or 2-propanol, IPA), and butanol (1- or 2-butanol, BuOH) are particularly preferred. These may be used alone or in combination.

The polymer concentration in the solution is preferably 5 to 20% by weight, and more preferably 6 to 18% by weight. If the polymer concentration is too low, the network structure of the membrane may not develop sufficiently, and the membrane itself may not withstand long-term use. If the polymer concentration is too high, the solution may not penetrate into the interior of the nonwoven fabric, and the membrane may not function. The ratio of solvent to non-solvent (solvent/non-solvent) is preferably 1 to 3, and more preferably 1.5 to 2.8. If the proportion of non-solvent is too high, the solubility of the polymer may be impaired, making it impossible to prepare a uniform solution and preventing sufficient impregnation. If the proportion of non-solvent is too low, it may not be able to promote phase separation.

The polymer material forming the membrane is hydrophobic. Therefore, it may be difficult to pass liquid through the membrane when the membrane is first used, and hydrophobic interactions tend to cause fouling problems. One preferable way to avoid this is to make the membrane hydrophilic.

General methods for hydrophilization include a method of adding a hydrophilizing agent to a polymer solution, a method of adding a hydrophilizing agent after forming a membrane, and a method of surface-treating a membrane. Among these, the preferred methods are the method of adding a hydrophilizing agent after forming a membrane and the method of surface-treating a membrane. The hydrophilizing agent is a chemical substance that has both hydrophobic portion and hydrophilic portion within a single molecule and has the function of adhering to the membrane surface and/or internal network. Examples thereof include sugars, cellulose derivatives, and surfactants. Specifically, examples thereof include hydroxypropyl cellulose, sucrose fatty acid esters, and sodium lauryl sulfate. Specific example of the method for hydrophilization after forming a membrane is a method of immersing the membrane in a solution containing the aforementioned hydrophilizing agent and then fixing it by applying heat or drying.

Next, an example of a method for producing the polymer porous flat membrane sheet of the present invention will be described. First, a nonwoven fabric is impregnated with a solution in which a polymer forming a membrane is dissolved. Any impregnation method can be used, such as an immersion method or an impregnation method using a die.

After impregnating the nonwoven fabric with the polymer solution, the resulting fabric is guided to a drying zone for solvent evaporation. At this stage, it is preferable to ensure that the membrane is not directly exposed to airflow. In the drying zone, it is important to control temperature and humidity. The preferred temperature is 10 to 40 °C, and more preferably 15 to 30 °C. The preferred relative humidity is 40 to 85%, and more preferably 50 to 85%.

Furthermore, when performing membrane formation by the dry method described above, it is preferable to use a combination of a solvent and a non-solvent having an appropriate vapor pressure in order to achieve a good membrane structure and pore diameter. As to the solvent, tetrahydrofuran or a mixed solvent mainly composed of tetrahydrofuran (50% by weight or more) can be selected. As to the non-solvent, 2-propanol, butanol, or a mixed solvent thereof can be selected. Preferably, a mixed solvent of two types, 2-propanol and 1-butanol, can be used.

The porous membrane obtained as described above is preferably hydrophilized. In order to maintain fouling resistance for as long as possible, it is preferable to apply an appropriate amount of a hydrophilizing agent, such as non-thermally denatured hydroxypropyl cellulose, to the membrane. As to the hydroxypropyl cellulose solution, it is preferable to use a hydroxypropyl cellulose solution prepared by uniformly dissolving hydroxypropyl cellulose at 0.5% to 1.0% by weight in an aqueous solution obtained by mixing 2-propanol and pure water in equal proportion by weight. Depending on properties of the porous membrane used, the ratio of 2-propanol to pure water and the amount of dissolved hydroxypropyl cellulose may be changed. After immersing the porous membrane in this hydroxypropyl cellulose solution, the excess solution is removed in a water washing bath or by a scraping spatula or a roller bar, and then heat treatment is performed to fix the hydroxypropyl cellulose to the membrane. This heat treatment is not limited to any particular method, such as a method of using hot water, warm air, or infrared irradiation. The hot-water treatment is preferred since it allows low-cost, simple, and uniform treatment. The temperature during the heat treatment is preferably 50 °C to 72 °C, and more preferably 60 °C to 70 °C. Subsequently, the membrane after the hydrophilization treatment is dried and rolled up. The drying conditions are preferably set at a temperature of 40 °C to 70 °C and a relative humidity of 1% to 20% in order to efficiently remove moisture and suppress thermal denaturation of the hydroxypropyl cellulose. These treatments are carried out continuously.

The flat membrane sheet produced in this manner can have, for example, an average pore diameter of 0.2 to 0.5 µm when measured using a Palm Porometer (PPM) manufactured by Porous Materials Inc. Furthermore, in this PPM measurement, a flow rate of the flat membrane sheet in a dry state can be 30 to 60 L/min at a pressure of 150 kPa. This range is determined in consideration of membrane strength and filtration efficiency during long-term use. A value of the flow rate indirectly reflects a degree of pore openness on the membrane surface and a density of the membrane structure. A larger value of the flow rate indicates a tendency for the membrane surface to have a greater degree of pore openness and a tendency for the membrane structure to be looser. Conversely, a smaller value of the flow rate indicates a tendency for the membrane surface to have a smaller degree of pore openness or for the membrane structure to be denser. Since these are closely related to membrane strength and filtration efficiency, the value of the flow rate can serve as an indicator of whether the membrane is capable of withstanding for long-term use.

The polymer porous membrane constituting the flat membrane sheet of the present invention preferably has a structure that gradually becomes looser from the surface in contact with the liquid to be treated to the inner portion when observed in a 5,000x electron micrograph of its cross-section. In addition, the polymer material forming the membrane preferably forms a three-dimensional mesh on a network and is appropriately intertwined with the nonwoven fabric of the membrane substrate. In this case, if the density of the network is too high, water permeability may be hindered, and if the density of the network is too low, the membrane components may detach from the substrate during long-term use, and the membrane may no longer be able to perform its function.

The apparatus of the present invention, which has the polymer porous flat membrane sheet and the cleaning means described above, and the method for regenerating development waste liquid using the apparatus, employ a high-performance flat membrane sheet that can filter-out and separate even fine particles. Therefore, not only the photosensitive resin composition that has flocculated in the development waste solution but also the photosensitive resin composition that has not flocculated but has dispersed can be efficiently collected. Moreover, the cleaning means aerates the flat membrane sheet such that the sponge pieces hit on deposits accumulated on the surface of the flat membrane sheet by filtration and separation and removes the deposits on the surface therefrom. Therefore, clogging of the membrane is effectively prevented, allowing high filtration performance to be maintained for a long time.

### Examples

The effects of the method and the apparatus of the present invention are demonstrated in the following Examples. The present invention is not limited to these Examples. The evaluation of specific values in the Examples was carried out according to the following method.

### (A) Particle size distribution measurement

Equipment: nanoSAQLA multi-sample nanoparticle size measurement system manufactured by Otsuka Electronics Co., Ltd.
Measurement conditions: cell type (glass cell), temperature (25°C), cumulative number of measurements (25 times)
Measurement principle: particle diameter measurement using dynamic light scattering method

Particles in a liquid constantly change their position, orientation, and morphology due to Brownian motion, such as translation and rotation. When these particles are irradiated with laser light and the resulting scattered light is detected, fluctuations in the scattering intensity depending on the Brownian motion of the particles are observed. Using this principle, by observing and analyzing the temporal fluctuations of the scattered light, the velocity of the Brownian motion of the particles (diffusion coefficient) can be obtained, and furthermore, the particle diameter can be determined.

### (B) Turbidity measurement

Equipment: WGZ-20B portable turbidimeter manufactured by REX.
Measurement conditions: LED light source, measurement wavelength 860 nm, measurement intensity NTU0.00-20
Measurement principle: 90-degree light-scattering method

When light from an LED light source is projected into a sample liquid, scattered light is generated in proportion to the concentration of suspended solids (SS)/turbidity-causing substances. Meanwhile, a photodetector positioned at a 90-degree angle relative to the light from the light source generates a current signal proportional to the scattered light. From this current signal, the turbidity value (mg/L) can be obtained.

### (Example of the present invention)

Using the apparatus 1 for producing a regenerated developer as shown in Figures 2 and 3, a performance in processing a development waste liquid (5% non-volatile components) containing the photosensitive resin composition was evaluated. As to the membrane element of the polymer porous flat membrane sheet, a laminate was used in which a resin mesh (DOP-18K manufactured by Nippon Filcon Co., Ltd.), a nonwoven fabric (polyethylene terephthalate nonwoven fabric, 05TH-60 manufactured by Hirose Paper Mfg. Co., Ltd.) and a separation membrane (membrane components made of chlorinated polyvinyl chloride, thickness 130 µm, average pore diameter 0.3 µm, pure water FR 30 mL/cm²/min/bar) were attached in this order to front and back surfaces of a support plate.

In order to enhance the physical cleaning of the membrane surface, hexahedral PVA sponge pieces (2 mm x 2 mm x 2 mm) were charged into the processing tank 10 of the apparatus 1 in an amount equivalent to 5% of the total volume.

Suction filtration operation was conducted using a tube pump at a filtration rate of 0.2m³ /day per 1 m² of membrane area of the membrane element. Specifically, intermittent operation was conducted by repeating a 7-minute suction filtration period and 3-minute stop period. The aeration rate was adjusted to 16 L/min per membrane element. The total duration of the suction filtration operation was 40 hours, and the non-volatile components of the concentrated development waste liquid at the end of the processing accounted for 20%.

The transmembrane pressure (TMP), which indicates the pressure difference between the permeate side and the feed side of the filtration membrane, was measured at the start and at the end of processing to evaluate the state of membrane clogging. The particle size distribution and turbidity of the development waste liquid before processing and the filtrate after processing were measured to evaluate the filtration performance. The evaluation results are as follows.
TMP: 8 kPa at the start of processing (estimated value from 0.2 m³/day); 29 kPa at the end of processing
Particle size in the liquid (size of maximum distribution): the development waste liquid before processing: 800 nm; the filtrate after processing: 80 nm
Turbidity of the liquid: the development waste liquid before processing: not measurable (opaque (white suspension)); the filtrate after processing:
19.1

### (Comparative Example 1)

Using the apparatus 1 for producing a regenerated developer as shown in Figures 2 and 3, a performance in processing a development waste liquid (5% non-volatile components) containing the photosensitive resin composition was evaluated. The procedure was carried out in the same manner as in the Example of the present invention, except that no sponge pieces were charged into the processing tank and no aeration was performed.

Suction filtration operation was conducted using a tube pump at a filtration rate of 0.2m³ /day per 1 m² of membrane area of the membrane element. Specifically, intermittent operation was conducted by repeating a 7-minute suction filtration period and 3-minute stop period. After the suction filtration operation was continued for a total of 18 hours, the operation was stopped due to clogging. The non-volatile components of the concentrated development waste liquid at the end of processing accounted for 11.8%.

The transmembrane pressure (TMP), which indicates the pressure difference between the permeate side and the feed side of the filtration membrane, was measured at the start and at the end of processing to evaluate the state of membrane clogging. The particle size distribution and turbidity of the development waste liquid before processing and the filtrate after processing were measured to evaluate the filtration performance. The evaluation results are as follows.
TMP: 8 kPa at the start of processing; 35 kPa at the end of processing
Particle size in the liquid (size of maximum distribution): the development waste liquid before processing: 800 nm; the filtrate after processing: 80 nm
Turbidity of the liquid: the development waste liquid before processing: not measurable (opaque (white suspension)); the filtrate after processing: 19.1

### (Comparative Example 2)

Using the apparatus 1 for producing a regenerated developer as shown in Figures 2 and 3, a performance in processing a development waste liquid (5% non-volatile components) containing the photosensitive resin composition was evaluated. Instead of the polymer porous flat membrane sheet, a membrane element was used in which a resin mesh (DOP-18K manufactured by Nippon Filcon Co., Ltd.) was attached to front and back surfaces of a support plate, and a filter (Bonden R301 manufactured by Kureha Tech Co., Ltd.) was attached thereon. No sponge pieces were charged into the processing tank.

Suction filtration operation was conducted using a tube pump at a filtration rate of 0.2m³ /day per 1 m² of membrane area of the membrane element. Specifically, intermittent operation was conducted by repeating a 7-minute suction filtration period and 3-minute stop period. The aeration rate was adjusted to 16 L/min per membrane element. The total duration of the suction filtration operation was 40 hours, and the non-volatile components of the concentrated development waste liquid at the end of the processing accounted for 6.3%.

The transmembrane pressure (TMP), which indicates the pressure difference between the permeate side and the feed side of the filtration membrane, was measured at the start and at the end of processing to evaluate the state of membrane clogging. The particle size distribution and turbidity of the development waste liquid before processing and the filtrate after processing were measured to evaluate the filtration performance. The evaluation results are as follows.
TMP: 0.4 kPa at the start of processing (estimated value); 2.0 kPa at the end of processing
Particle size in the liquid (size of maximum distribution): the development waste liquid before processing: 800 nm; the filtrate after processing: 750 nm
Turbidity of the liquid: the development waste liquid before processing: not measurable (opaque (white suspension)); the filtrate after processing: not measurable (outside the detectable range of this measurement method).

### Industrial Applicability

According to the method and the apparatus of the present invention, not only flocculate of the photosensitive resin composition but also the photosensitive resin compositions which has not flocculated but has dispersed can be efficiently removed from the development waste liquid, making it easy to obtain a regenerated developer. Furthermore, clogging of the flat membrane sheet is less likely to occur, and high filtration performance can be maintained. Therefore, the method and the apparatus of the present invention are extremely useful in the industry.

### Explanation of Reference Number

- 1: Apparatus for producing a regenerated developer
- 10: Processing tank
- 11: Polymer porous flat membrane sheet
- 12: Membrane element
- 13: Water collection pipe
- 14: Cleaning means
- 21: (Development waste liquid) transport direction
- 22: (Regenerated developer) transport direction
- 31: Transport direction
- 32: Developing brush
- 33: Developer tank
- 34: Developer pump
- 35: Transfer switching valve
- 36: Regenerative developer pump
- 37: Rinse brush
- 38: Regenerated developer outlet
- 39: Developer outlet

## Claims

1. A method for producing a regenerated developer from a development waste liquid generated by developing a water-developable flexographic printing plate precursor having a photosensitive resin layer made of a photosensitive resin composition containing a water-dispersible resin, comprising:
guiding the development waste liquid into a processing tank, and separating and removing the photosensitive resin composition which has been contained in the development waste liquid using a polymer porous flat membrane sheet provided in the processing tank to obtain the regenerated developer; and
charging sponge pieces into the processing tank and aerating the polymer porous flat membrane sheet such that the sponge pieces hit on the polymer porous flat membrane sheet, thereby removing deposits on the polymer porous flat membrane sheet therefrom for cleaning the flat membrane sheet.

2. The method according to claim 1, wherein the polymer porous flat membrane sheet comprises a polymer porous membrane that forms a mesh-like network structure and a sheet-like substrate that supports the polymer porous membrane.

3. The method according to Claim 1 or 2, wherein the sponge pieces are made of a material that has a specific gravity greater than a specific gravity of the liquid in the processing tank when the sponge pieces retain water and wherein the material has a maximum edge dimension of 0.1 to 10 mm.

4. An apparatus for producing a regenerated developer from a development waste liquid generated by developing a water-developable flexographic printing plate precursor having a photosensitive resin layer made of a photosensitive resin composition containing a water-dispersible resin,
wherein the apparatus has a processing tank for receiving the development waste liquid and separating and removing the photosensitive resin composition which has been contained in the development waste liquid,
wherein the processing tank is equipped with a polymer porous flat membrane sheet for separating and removing the photosensitive resin composition from the development waste liquid, and
wherein the processing tank comprises sponge pieces charged into the processing tank and a cleaning means configured to remove deposits on the polymer porous flat membrane sheet therefrom by aerating the polymer porous flat membrane sheet such that the sponge pieces hit on the polymer porous flat membrane sheet.

5. The apparatus according to Claim 4, wherein the polymer porous flat membrane sheet comprises a polymer porous membrane that forms a mesh-like network structure and a sheet-like substrate that supports the polymer porous membrane.

6. The apparatus according to Claim 4 or 5, wherein the sponge pieces are made of a material that has a specific gravity greater than a specific gravity of the liquid in the processing tank when the sponge pieces retain water, and wherein the material has a maximum edge dimension of 0.1 to 10 mm.
